# EUROPEAN PATENT APPLICATION

(11) **EP 4 729 293 A1**
(43) Date of publication of application: **22.04.2026**
(21) Application number: 24215158.7
(22) Date of filing: 25.11.2024
(51) Int. Cl.: B32B 18/00, C04B 35/563, C04B 35/573, C04B 35/58, C04B 35/584, C04B 35/626

(54) **PHOTOCURING CERAMIC SLURRY AND COMPONENTS MANUFACTURED THEREFROM FOR THERMAL MANAGEMENT APPLICATIONS**

(30) Priority: 21.10.2024 US 202418912921
(71) Applicant: II-VI Delaware, Inc., Wilmington, Delaware 19801 (US)
(72) Inventor: Wang, Jiwen, Glastonbury, CT (US); Coppola, Jonathan, Ansonia, 06418 (US); Aghajanian, Michael, Newark, 19711 (US)
(74) Representative: Forresters IP LLP

(57) **Abstract**

The present disclosure provides a novel method for fabricating thermal management devices. The present disclosure is directed to a photocuring ceramic slurry comprising: 50 to 70 wt. % opaque ceramic particles; 30 to 50 wt. % light curing resin; and 0.3 to 1 wt. % dispersing agent, wherein the dispersing agent promotes light to penetrate and cure the photocuring slurry. Thermal management components manufactured from slurries include a vacuum wafer chuck with internal water-cooling channels and a micro-cooler heat management device with internal channels and pins.

## Description

### BACKGROUND

### Field

This disclosed subject matter relates generally to a photocuring ceramic slurry, methods of making ceramic components from the photocuring ceramic slurry, and the ceramic components produced by the methods.

### Technical Considerations

Reaction bonded ceramic components containing internal features are important to the semiconductor industry. Example components include, but are not limited to, water-cooled wafer tables, water-cooled collector mirrors, water-cooled high energy laser mirrors, and water-cooled micro-cooler systems for electronic devices. Conventional parts may be made by forming preform pieces/portions (e.g., two preform halves) with surface features (e.g., channels), bonding the preform pieces with a silicon carbide (SiC)-based glue or adhesive (a caulk-like material) and thermal processing (such as, e.g., ceramic firing, reaction bonding, etc.) to yield a one-piece ceramic body finished component with internal features.

During conventional preform bonding operations as described above, a slight bead of excess SiC-based glue may extrude into the feature, such as a channel in the finished component. If the channel or other feature size is large (5 to 10 mm), excess glue may not pose a problem. However, many next-generation designs have ultra-small feature sizes (e.g., < 1 mm; in some embodiments, 0.25-1.0 mm, or 0.5-1.0 mm). A bead of excess glue may restrict flow or even clog features of this small size, making it difficult to produce parts with ultra-small features.

Reaction bonded pieces may be glass bonded to try to avoid the excess glue problem, but this type of bonding has poor corrosion resistance, poor thermal conductivity, poor electrical conductivity and/or poor elevated temperature strength. It is also subject to failure if any high-temperature, post-processing is required.

Consequently, improved methods for producing reaction bonding components with fine internal features are desirable.

### SUMMARY

Accordingly, it is an object of the presently disclosed subject matter to provide a photocuring ceramic slurry for producing ceramic components that overcomes some or all of the deficiencies identified above.

According to non-limiting embodiments or aspects, provided is a photocuring ceramic slurry comprising: 50 to 70 wt. % opaque ceramic particles; 30 to 50 wt. % light curing resin; and 0.3 to 1 wt. % dispersing agent, wherein the dispersing agent promotes light to penetrate and cure the photocuring slurry.

In some non-limiting embodiments or aspects, the slurry may further comprise: 0 to 5 wt. % photoinitiator.

In some non-limiting embodiments or aspects, the opaque ceramic particles may be selected from the group consisting of silicon carbide, boron carbide, silicon nitride, and titanium diboride. In some non-limiting embodiments or aspects, the opaque ceramic particles may comprise an average particle size of from about 5 to 30 µm.

In some non-limiting embodiments or aspects, the slurry may further comprise elemental silicon.

In some non-limiting embodiments or aspects, the light curing resin may comprise an ultraviolet digital light processing resin.

In some non-limiting embodiments or aspects, the slurry may have a viscosity of about 1,000 to 30,000 cps at temperatures ranging from about 20 to 50°C.

In some non-limiting embodiments or aspects, the dispersing agent may cause the slurry to have a light transmission depth of about 25 µm or more.

According to non-limiting embodiments or aspects, also provided is a method of making a ceramic component from a photocuring slurry, the method comprising: placing the photocuring slurry in a light curing resin tank, subjecting the slurry to light to cause a portion of the slurry to react and form a preform ceramic component; and reaction bonding the preform ceramic component to yield a ceramic component. The photocuring slurry may comprise: 50 to 70 wt. % opaque ceramic particles; 30 to 50 wt. % light curing resin; and 0.3 to 1 wt. % dispersing agent.

In some non-limiting embodiments or aspects, the method may be performed using a digital light processing three-dimensional printer.

In some non-limiting embodiments or aspects, subjecting the slurry to light may comprise: providing ultraviolet (UV) light to a section of the slurry in the light curing resin tank using an UV light source, wherein the UV light is provided at about 300 to 450 nm wavelength.

In some non-limiting embodiments or aspects, the method may further comprise: projecting a two-dimensional image of each layer of the preform ceramic component; and curing each layer of the preform ceramic component using an ultraviolet light source to form the preform ceramic component.

In some non-limiting embodiments or aspects, one or more layers of the preform ceramic component may include surface features comprising channels or grooves. In some non-limiting embodiments or aspects, the channel or groove size may range from about 0.2 to 5 mm in length, width, and/or depth.

In some non-limiting embodiments or aspects, the method may further comprise: draining any unreacted slurry from the preform ceramic component.

In some non-limiting embodiments or aspects, the method may further comprise: pyrolizing the preform ceramic component to convert any resin into carbon.

In some non-limiting embodiments or aspects, reaction bonding may comprise Si infiltration.

In some non-limiting embodiments or aspects, the reaction bonded ceramic component may comprise silicon carbide, boron carbide, pure carbon, silicon nitride, and/or titanium diboride.

According to non-limiting embodiments or aspects, also provided is a vacuum wafer chuck comprising: a main body portion, internal channels ranging in size from about 0.2-5 mm in length, width and in depth, and discrete pins for supporting a semiconductor wafer, wherein the pins are located at least partially within the main body portion, and the main body portion and pins are formed from a photocuring ceramic slurry comprising: 50 to 70 wt. % opaque ceramic particles; 30 to 50 wt. % light curing resin; and 0.3 to 1 wt. % dispersing agent.

According to non-limiting embodiments or aspects, also provided is a heat management device, comprising: a ceramic body; and a network of channels defined in a surface of the ceramic body, wherein the ceramic body is formed from a photocuring ceramic slurry comprising: 50 to 70 wt. % opaque ceramic particles; 30 to 50 wt. % light curing resin; and 0.3 to 1 wt. % dispersing agent. In some non-limiting embodiments or aspects, the ceramic body may comprise a silicon carbide and/or a boron carbide body.

According to non-limiting embodiments or aspects, also provided is a heat management device, comprising: a ceramic body; and a network of internal channels and/or chambers in the ceramic body, wherein the ceramic body is formed from a photocuring ceramic slurry comprising: 50 to 70 wt. % opaque ceramic particles; 30 to 50 wt. % light curing resin; and 0.3 to 1 wt. % dispersing agent. In some non-limiting embodiments or aspects, the ceramic body may comprise silicon carbide and is formed by digital light processing 3D printing. In some non-limiting embodiments or aspects, the channel or chamber size may range from about 0.2 to 5 mm in length, width, and/or depth.

Further embodiments or aspects are set forth in the following numbered clauses:
Clause 1: A photocuring ceramic slurry comprising: 50 to 70 wt. % opaque ceramic particles; 30 to 50 wt. % light curing resin; and 0.3 to 1 wt. % dispersing agent, wherein the dispersing agent promotes light to penetrate and cure the photocuring slurry.
Clause 2: The slurry of clause 1, further comprising: 0 to 5 wt. % photoinitiator.
Clause 3: The slurry of clause 1 or 2, wherein the opaque ceramic particles are selected from the group consisting of silicon carbide, boron carbide, silicon nitride, and titanium diboride.
Clause 4: The slurry of any of clauses 1-3, wherein the opaque ceramic particles comprise an average particle size of from about 5 -30 µm.
Clause 5: The slurry of any of clauses 1-4, wherein the slurry further comprises elemental silicon.
Clause 6: The slurry of any of clauses 1-5, wherein the light curing resin comprises an ultraviolet digital light processing resin.
Clause 7: The slurry of any of clauses 1-6, wherein the slurry has a viscosity of about 1,000 to 30,000 cps at temperatures ranging from 20 to 50°C.
Clause 8: The slurry of any of clauses 1-7, wherein the dispersing agent causes the slurry to have a light transmission depth of about 25 um or more.
Clause 9: A method of making a ceramic component from a photocuring slurry, the method comprising: placing the photocuring slurry in a light curing resin tank, subjecting the slurry to light to cause a portion of the slurry to react and form a preform ceramic component; and reaction bonding the preform ceramic component to yield a ceramic component. The photocuring slurry may comprise: 50 to 70 wt. % opaque ceramic particles; 30 to 50 wt. % light curing resin; and 0.3 to 1 wt. % dispersing agent.
Clause 10: The method of clause 9, wherein the method is performed using a digital light processing three-dimensional printer.
Clause 11: The method of clause 9 or 10, wherein subjecting the slurry to light comprises: providing ultraviolet (UV) light to a section of the slurry in the light curing resin tank using an UV light source, wherein the UV light is provided at about 300 to 450 nm wavelength.
Clause 12: The method of any of clauses 9-11, further comprising: projecting a two-dimensional image of each layer of the preform ceramic component; and curing each layer of the preform ceramic component using an ultraviolet light source to form the preform ceramic component.
Clause 13: The method of any of clauses 9-12, wherein one or more layers of the preform ceramic component include surface features comprising channels or grooves.
Clause 14: The method of any of clauses 9-13, wherein the channel or groove size ranges from about 0.2 to 5 mm in length, width, and/or depth.
Clause 15: The method of any of clauses 9-14, further comprising: draining any unreacted slurry from the preform ceramic component.
Clause 16: The method of any of clauses 9-15, further comprising: pyrolizing the preform ceramic component to convert any resin into carbon.
Clause 17: The method of any of clauses 9-16, wherein reaction bonding comprises Si infiltration.
Clause 18: The method of any of clauses 9-17, wherein the reaction bonded ceramic component comprises silicon carbide, boron carbide, pure carbon, silicon nitride, and/or titanium diboride.
Clause 19: A vacuum wafer chuck comprising: a main body portion, and discrete pins for supporting a semiconductor wafer, wherein the pins are located at least partially within the main body portion, and wherein the main body portion and pins are formed from a photocuring ceramic slurry comprising: 50 to 70 wt. % opaque ceramic particles; 30 to 50 wt. % light curing resin; and 0.3 to 1 wt. % dispersing agent.
Clause 20: A heat management device, comprising: a ceramic body; and a network of channels defined in a surface of the ceramic body, wherein the ceramic body is formed from a photocuring ceramic slurry comprising: 50 to 70 wt. % opaque ceramic particles; 30 to 50 wt. % light curing resin; and 0.3 to 1 wt. % dispersing agent.
Clause 21: The heat management device of clause 20, wherein the ceramic body comprises a silicon carbide and/or a boron carbide body.
Clause 22: A heat management device, comprising: a ceramic body; and a network of internal channels and/or chambers in the ceramic body, wherein the ceramic body is formed from a photocuring ceramic slurry comprising: 50 to 70 wt. % opaque ceramic particles; 30 to 50 wt. % light curing resin; and 0.3 to 1 wt. % dispersing agent.
Clause 23: The heat management device of clause 22, wherein the ceramic body comprises silicon carbide and is formed by digital light processing 3D printing.
Clause 24: The heat management device of clause 22 or clause 23, in some non-limiting embodiments or aspects, wherein the channel or chamber size ranges from about 0.2 to 5 mm in length, width, and/or depth.

These and other features and characteristics of the presently disclosed subject matter, as well as the methods of operation and functions of the related elements of structures and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the disclosed subject matter. As used in the specification and the claims, the singular forms of "a," "an," and "the" include plural referents unless the context clearly dictates otherwise.

### BRIEF DESCRIPTION OF THE DRAWINGS

Additional advantages and details of the disclosed subject matter are explained in greater detail below with reference to the exemplary embodiments or aspects that are illustrated in the accompanying figures, in which:
FIGS. 1A-1C show traditional steps in producing net-shape reaction bonded components, with FIG. 1A being a preform blank, FIG. 1B being green machined near net shape, and FIG. 1C being a reaction bonded component;
FIG. 2 shows a schematic diagram of a digital light processing (DLP) printer set up according to some non-limiting embodiments or aspects of the presently disclosed subject matter;
FIGS. 3A-3B show solid components produced via DLP according to some non-limiting embodiments or aspects of the presently disclosed subject matter;
FIG. 4 shows a viscosity profile for a particular slurry composition without a dispersing agent according to some non-limiting embodiments or aspects of the presently disclosed subject matter;
FIG. 5 shows a viscosity profile for a particular slurry composition with a dispersing agent according to some non-limiting embodiments or aspects of the presently disclosed subject matter;
FIGS. 6A-6C show components having channels produced via DLP according to some non-limiting embodiments or aspects of the presently disclosed subject matter;
FIGS. 7A-7B show schematic diagrams of a preform (FIG. 7A) and reaction bonded (FIG. 7B) material according to some non-limiting embodiments or aspects of the presently disclosed subject matter;
FIGS. 8A-8B show schematic diagrams of a preform (FIG. 8A) and reaction bonded (FIG. 8B) material according to some non-limiting embodiments or aspects of the presently disclosed subject matter;
FIG. 9 shows a cross-sectional microscopic image of a reaction bonded DLP SiC preform manufactured according to some non-limiting embodiments or aspects of the presently disclosed subject matter;
FIG. 10 shows a perspective view of a ceramic body formed as a micro-cooler thermal management device according to some non-limiting embodiments or aspects of the presently disclosed subject matter;
FIGS. 11A-11C show various views of a ceramic body formed as a micro-cooler thermal management device according to some non-limiting embodiments or aspects of the presently disclosed subject matter; and
FIGS. 12A-12B show a top view of a ceramic body formed as a micro-cooler thermal management device as a preform (FIG. 12A) and reaction bonded (FIG. 12B) according to some non-limiting embodiments or aspects of the presently disclosed subject matter.

### DESCRIPTION

For purposes of the description hereinafter, the terms "end," "upper," "lower," "right," "left," "vertical," "horizontal," "top," "bottom," "lateral," "longitudinal," and derivatives thereof shall relate to the disclosed subject matter as it is oriented in the drawing figures. However, it is to be understood that the disclosed subject matter may assume various alternative variations and step sequences, except where expressly specified to the contrary. It is also to be understood that the specific devices and processes illustrated in the attached drawings, and described in the following specification, are simply exemplary embodiments or aspects of the disclosed subject matter. Hence, specific dimensions and other physical characteristics related to the embodiments or aspects disclosed herein are not to be considered as limiting unless otherwise indicated.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise.

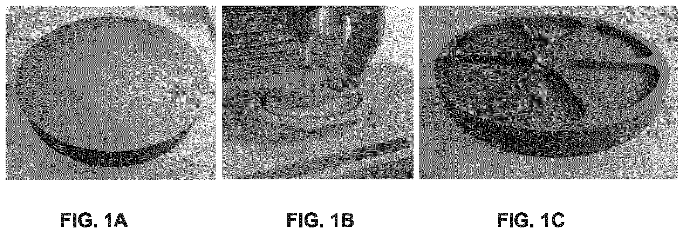

Turning initially to FIG. 1, a traditional set of steps for forming a reaction bonded component is provided. Fig. 1A shows a SiC and carbon preform blank. This SiC and carbon preform blank may be formed by traditional methods known in the art. Once the preform blank is formed, it may be green machined to produce a near-net shape, such as shown in FIG. 1B. This green machining may also be done by traditional methods known in the art. Once the near-net shape is formed, it may be reaction bonded using known methods, such as Si infiltration, shown in Fig. 1C.

There are a number of issues related to the steps shown in FIG. 1. For example, there is a substantial amount of cost in terms of labor and equipment. Each of the steps contribute to a long cycle time. The green machining lends itself to high raw material waste. Additionally, it is challenging to create internal channels and cavities in manufactured components.

Consequently, new methods of producing ceramic components where internal chambers can be reliably produced is desired. One such method involves digital light processing (DLP) three-dimensional (3D) printing.

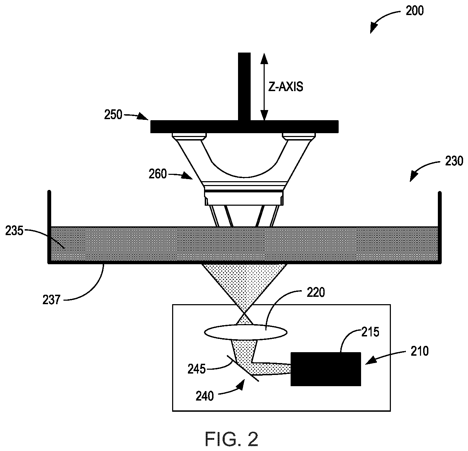

Turning to FIG. 2, an example schematic diagram of a DLP printer is provided. In DLP, patterned light is used to cure a layer of material at a time within a resin tank. In FIG. 2, a DLP system 200 includes a high resolution or digital light projector 210 including a light source 215, a lens 220, a resin tank 230 filled with a liquid photopolymer, a mirror 240 and a build platform 250. As shown, mirror 240 is a digital micromirror device (DMD) 245.

The only photopolymer that gets cured is that which is both illuminated and physically in contact with a solid surface (e.g., the build platform 250 or a previous layer). DLP printers run a peeling action across the bottom 237 of the resin tank 230 after each layer to remove any resin that cured at the bottom 237 of the tank. Once a layer is complete, the build platform 250 moves up by the thickness of one layer (e.g., upward along the z-axis), and the process is repeated until the part 260 is completed.

The DLP process is fast, low cost, provides high tolerances and can produce parts with internal cavities and channels. DLP is commonly used to produce plastic parts, using UV cure resins, and polymer/ceramic composites using UV transparent ceramic particles such as porcelain, quartz, and aluminum oxide. However, DLP is not well suited to produce polymer/UV opaque ceramic composites when the ceramics are dark or opaque particles, which do not allow for proper light penetration allowing curing of the polymer resin.

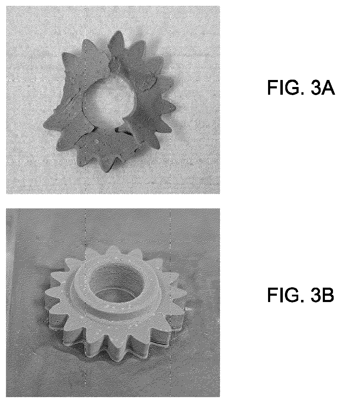

Turning to FIG. 3A, a typical polymer/SiC composite component produced from a resin is shown. The slurry for the component in FIG. 3A includes SiC ceramic particles mixed into a light curing polymer resin. SiC is an "opaque" ceramic that has low UV light transmittance. In contrast, in FIG. 3B, a polymer/SiC composite component is produced where an additive to allow light to penetrate the resin is shown. The slurry for the component in FIG. 3B includes SiC ceramic particles mixed into a light curing polymer resin and a dispersing agent. From comparing FIG. 3A with FIG. 3B, it should be appreciated that the composite component produced in FIG. 3A is poorly printed and fragmented, while the composite component produced in FIG. 3B is well printed and solid.

Non-limiting embodiments or aspects of the disclosed subject matter are directed to a photocuring ceramic slurry including: 50 to 70 wt.% opaque ceramic particles; 30 to 50 wt.% light curing resin; and 0.3 to 1 wt.% dispersing agent, wherein the dispersing agent promotes light to penetrate and cure the photocuring slurry. In some non-limiting embodiments or aspects, the photocuring slurry includes greater than 55 wt.% of opaque ceramic particles or more, with an increased percentage of ceramic particles preferable as indicative of better particle packing. As used herein, opaque means particles having a low UV transmittance.

In some non-limiting embodiments or aspects, the opaque ceramic particles may be selected from the group including silicon carbide, boron carbide, silicon nitride, titanium diboride, and combinations thereof. In some non-limiting embodiments or aspects, the opaque ceramic particles may have an average particle size of from 5-30 µm. Such ceramic particle sizes may promote reaction bonding in later processing steps.

In some non-limiting embodiments or aspects, the slurry may include additional components. For example, the slurry may include elemental silicon and/or boron. The slurry may include a photoinitiator, such as is commonly used in DLP printing in a suitable amount, such as 0 to 5 wt. % photoinitiator.

Ceramic slurries made in accordance with the present disclosure generally include a dispersing agent or dispersant. While the dispersing agent is listed as 1 wt.% or less in the slurry, there may be slurry compositions that would benefit from a larger amount of dispersing agent, such as up to 2 wt.% or higher.

Suitable dispersing agents include those commercially available, such as Tamol 963^{®} from Dow Chemical. In some non-limiting embodiments or aspects, the dispersing agent causes the slurry to have a light transmission depth of 25 µm or more. In some non-limiting embodiments or aspects, the dispersing agent causes the slurry to have a light transmission depth of 50 µm or more. For example, the dispersing agent may separate the particles at the micro-level, creating space for the light to penetrate. Having a greater light transmission depth extending to two or more layers in the DLP printing depth may be advantageous in ensuring that light can fully penetrate the slurry and fully cure the resultant components.

In some non-limiting embodiments or aspects, the light curing resin may be any suitable ultraviolet digital light processing resin for use in a DLP printer. Suitable light curing resins include those commercially available, such as Anycubic's standard UV resin. It is appreciated that these light curing resins are for example only, and that any suitable light curing resin may be used.

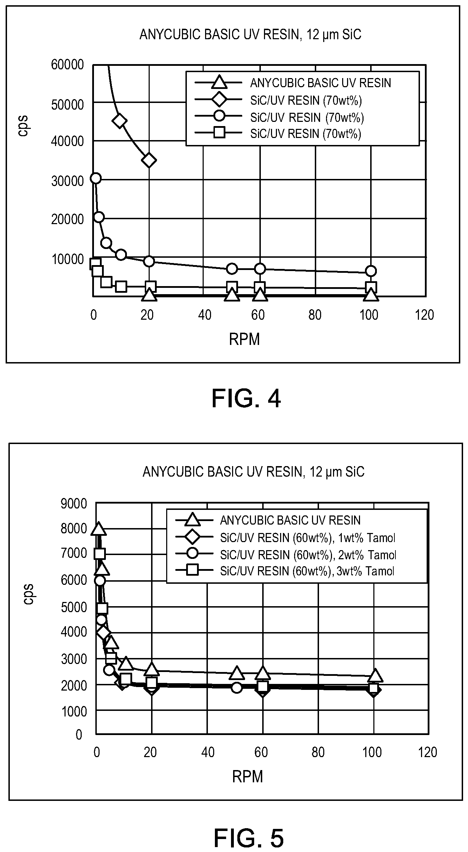

Turning first to FIG. 4, a viscosity profile of a 12 µm SiC powder blended with a UV resin slip is shown. The UV resin used is the standard Anycubic UV polymer resin for DLP 3D printing. The viscosity profile includes a number of related profiles including a UV resin only profile, and UV resin with SiC profiles with 60, 67 and 70 wt% SiC.

In FIG. 4, the viscosity is shown along the y-axis and indicated by centipoise (cps). The velocity is shown along the x-axis and indicated by revolutions per minute (rpm). A fluid with a low centipoise will flow and move easily and fast. A rating of a higher centipoise is going to flow much slower. In FIG. 4, the viscosity scale ranges from 0 to 60,000 cps, with increments shown in 10,000 cps. The velocity scale ranges from 0 to 100 rpm, with increments shown in 20 rpm.

From looking at FIG. 4, it is expected that the UV resin only profile would be the least viscous, flowing and moving easily and fast. It is also not surprising that the SiC and resin profile with the lowest amount of UV resin would be the most viscous, seemingly only able to flow up to 20 rpms. What is interesting is how a small change in the amount of resin for the SiC 67 wt.% profile and SiC 60 wt.% profile produce such a large drop in viscosity, allowing these resin slips to operate similar to the UV resin only profile.

Turning now to FIG. 5, a viscosity profile of a 12 µm SiC powder blended with a UV resin slip is shown. The UV resin used is the standard Anycubic UV polymer resin for DLP 3D printing. The viscosity profile includes a number of related profiles including a 60 wt% SiC and UV resin profile, a 60 wt% SiC and UV resin with 1 wt.% dispersant profile, a 60 wt% SiC and UV resin with 2 wt.% dispersing agent profile, and a 60 wt% SiC and UV resin with 3 wt.% dispersing agent profile. The dispersant used is Tamol 963^{®} commercial dispersing agent.

In FIG. 5, the viscosity scale ranges from 0 to 8,000 cps, with increments shown in 1,000 cps. The velocity scale ranges from 0 to 100 rpm, with increments shown in 20 rpm. From comparing FIG. 4 with FIG. 5, it should be apparent that 60 wt% SiC and UV resin profile is the same as 60 wt% SiC and UV resin profile, with different scaling shown. This is meant to illustrate the effects of adding the dispersant to profiles in FIG. 5.

Looking at the 60 wt% SiC and UV resin with 1 wt.% dispersant profile, 60 wt% SiC and UV resin with 2 wt.% dispersing agent profile, and 60 wt% SiC and UV resin with 3 wt.% dispersing agent profile, the performance looks roughly the same. It should be noted that adding just a small amount of a dispersing agent decreases the viscosity of the prepared slips by about 500 cps at 100 rpm, as compared to the 60 wt% SiC and UV resin profile. A lower viscosity in the prepared slips or slurries is preferred because it allows a higher content of ceramic particles (e.g., SiC) to be added.

In general, higher ceramic content slurries allow DLP printing of higher ceramic content preforms. Higher ceramic content preforms are better for ceramic processing, e.g., reducing the component shrinkage, improving the dimension accuracy after infiltration, etc.

In some non-limiting embodiments or aspects, the slurry may have a viscosity of 1,000 to 30,000 cps at temperatures ranging from 20 to 50°C. These temperatures may be referred to as "bath temperatures" for the printer, which may be measured at the resin tank.

Turning back to FIG. 3A and 3B, the components were produced via DLP using slips with 60 wt % 12 µm SiC powder blended with Anycubic Basic UV resin (FIG. 3A) and 60 wt % 12 µm SiC powder blended with Anycubic Basic UV resin with 1 wt.% Tamol 963^{®} (FIG. 3A). While not wishing to be bound by any particular theory, it is believed that the DLP printing of slurries of SiC powder and UV resin is difficult because SiC is a "UV dark particle," meaning that the UV light cannot adequately penetrate the slurry for a deep curing. This is illustrated by the poorly printed component in FIG. 3A.

In contrast, in FIG. 3B, adding the dispersing agent greatly enhanced printing. This is believed to be caused by microscale particle separation that the dispersing agent provides, yielding a pathway from the light to penetrate deeper in the resin. Hence, UV light was able to penetrate a slurry with dispersed particle and to produce the component in FIG. 3B.

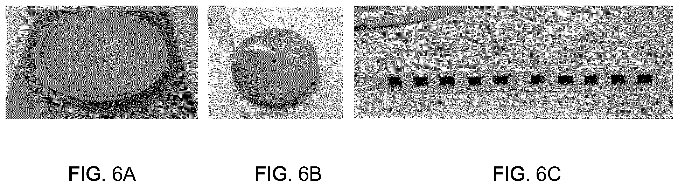

Referring now to FIGS. 6A-6C, an example pinned wafer chuck component produced via DLP using a SiC slurry having a dispersing agent is shown. As provided above, DLP is well suited to produce components having small channel geometries. Because DLP is a liquid-based process, it allows draining of channels after the printing step, which is difficult to achieve by other 3D printing methods such as powder bed related 3D printing.

FIG. 6A shows a near net shape of a polymer preform component printed from DLP. FIG. 6B shows the preform component of FIG. 6A undergoing a draining of the sample. FIG. 6C shows the preform component after draining, with the channels fully visible.

Non-limiting embodiments or aspects of the disclosed subject matter are directed to a method of making a ceramic component from a photocuring slurry, the method including: placing the photocuring slurry in a light curing resin tank, subjecting the slurry to light to cause a portion of the slurry react and form a preform ceramic component; and reaction bonding the preform ceramic component to yield a ceramic component. The photocuring slurry may include: 50 to 70 wt. % opaque ceramic particles; 30 to 50 wt. % light curing resin; and 0.3 to 1 wt. % dispersing agent.

In some non-limiting embodiments or aspects, the method may be performed using a DLP 3D printer. As used herein, the terms digital light processing three-dimensional printer, DLP printer, and DLP 3D printer may use interchangeably and refer to the same type of printer. It should be appreciated that while the schematic assembly provided in FIG. 2 included a number of components, it was not exhaustive. For example, any suitable DLP 3D printer may be used to produce ceramic components from slurries disclosed herein.

In some non-limiting embodiments or aspects, the light source is preferably a UV light source, such as typically included in DLP printers. In some non-limiting embodiments or aspects, UV light is provided at about 300 to 450 nm wavelength, with a light intensity of about 1 to 50 mW/cm².

In some non-limiting embodiments or aspects, subjecting the slurry to light may include: providing ultraviolet (UV) light to a section of the slurry in the light curing resin tank using an UV light source, where the UV light is provided at about 300 to 450 nm wavelength. The light intensity may vary but is generally about 1 to 50 mW/cm².

In some non-limiting embodiments or aspects, the DLP printer includes a projector configured to project a two-dimensional image of each layer of the preform ceramic component. Once projected onto the bottom surface of the resin tank, each layer of the perform ceramic component is cured using the UV light source. The collective of layers forms the preform ceramic component, such as shown in FIG. 6.

In some non-limiting embodiments or aspects, one or more layers of the preform ceramic component may include surface features including channels or grooves, such as shown in FIG. 3B and FIG. 6C. The channel or groove size may range from about 0.2 to 5 mm in length, width, and/or depth. In some non-limiting embodiments or aspects, channel or groove size may range from about 0.6 to 2 mm in length, width, and/or depth.

As shown in FIG. 6B, after the preform ceramic component is formed, any unreacted slurry may be drained from the preform ceramic component.

After 3D DLP printing a slurry of SiC particles and resin (polymer) to a near net shape, such as shown in FIG. 6A-6C, the SiC/polymer preform is carbonized or pyrolyzed to convert the polymer to carbon (e.g., pyrolysis). For example, a carbonization or pyrolysis process may be conducted at 600°C using N₂, or other suitable parameters to cause the polymer in the preform to pyrolize and convert to carbon. The resulting SiC and carbon preform is preferred for reaction bonding (Si infiltration) process.

Once the SiC preform is formed, it may be reaction bonded like traditionally produced preform components, described for FIG. 1. For example, while not shown, subsequent reaction bonding yields fully dense SiSiC ceramic components with internal channels for the preform component of FIG. 6C.

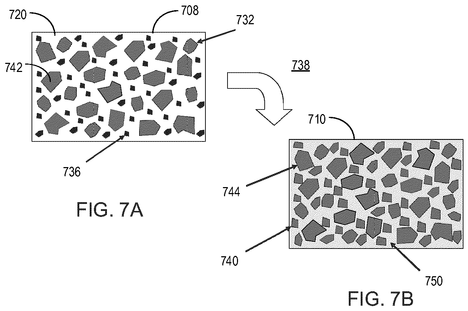

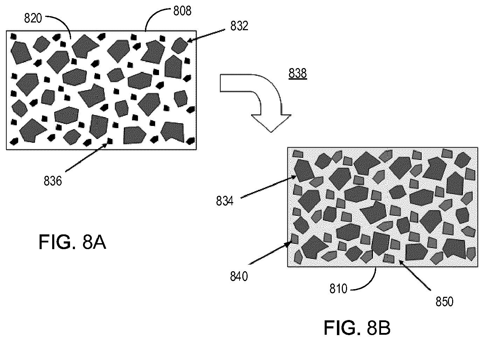

Referring now to FIGS. 7-8, schematic diagrams of a preform (FIGS. 7A, 8A) and reaction bonded (FIGS. 7B, 8B) material according to some non-limiting embodiments or aspects of the presently disclosed subject matter are shown. FIG. 7 shows the process for reaction bonding SiC and FIG. 8 shows the process for reaction bonding boron carbide (B₄C).

FIG. 7A shows a preform material 708. The preform material 708 may include ceramic particles 732 and carbon particles 736. As shown, the ceramic particles 732 are silicon carbide 742. In some non-limiting embodiments or aspects, the ceramic particles may include silicon nitride and titanium diboride.

The preform material 708 may further include residual elemental silicon and/or boron. In some non-limiting embodiments or aspects, preform material 708 includes void space 720.

FIG. 7B shows a reaction-bonded ceramic material 710. The material 710 may be formed by applying a silicon (or alloy of silicon with aluminum, boron, titanium, and/or the like) infiltration process. In the non-limiting example shown in FIG. 7B, molten silicon 738 may infiltrate the preform material 708 from FIG. 7A to form the material 710 in FIG. 7B. The molten silicon 738 may react with the carbon particles 736 to form reaction formed SiC particles 740 in addition to the unreacted SiC particles 744. The material 710 may further include residual elemental silicon and/or silicon alloy. In some non-limiting embodiments or aspects, material 710 includes residual Si 750.

Similarly, FIG. 8A shows a preform material 808. The preform material 808 may include boron carbide ceramic particles or boron carbide and silicon carbide particles 832 and carbon particles 836. The preform material 808 may further include residual elemental silicon and/or boron. In some non-limiting embodiments or aspects, preform material 808 includes void space 820.

FIG. 8B shows a reaction-bonded ceramic material 810. The material 810 may be formed by applying a silicon (or alloy of silicon with aluminum, boron, titanium, and/or the like) infiltration process. In the non-limiting example shown in FIG. 8B, molten silicon 838 may infiltrate the preform material 808 from FIG. 8A to form the material 810 in FIG. 8B. The molten silicon 838 may react with the carbon particles 836 to form reaction formed SiC particles 840 in addition to the unreacted boron carbide and/or silicon carbide particles. The material 810 may further include residual elemental silicon and/or silicon alloy. In some non-limiting embodiments or aspects, material 810 includes residual Si 850.

The material 710, 810 formed may exhibit the beneficial properties of having a low thermal expansion, a high thermal conductivity, a high hardness, a high wear resistance, a high stiffness, high temperature capability, and/or a low coefficient of friction.

In some non-limiting embodiments, Al may be incorporated into the Si infiltration. Enhancements from Al-modified reaction bonded SiC include a tailorable CTE, higher thermal conductivity and higher fracture toughness.

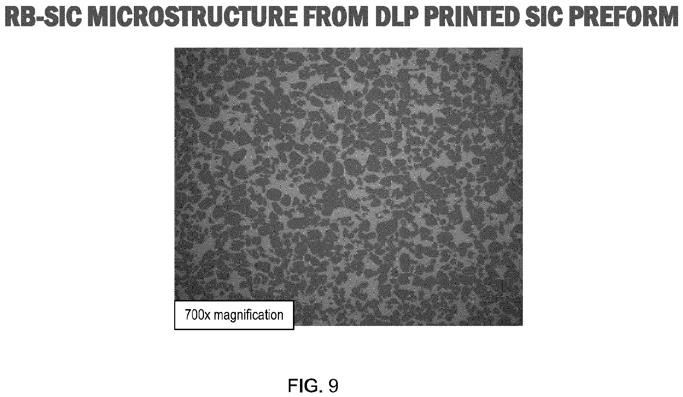

Referring now to FIG. 9, a cross-sectional microscopic image of a reaction bonded DLP SiC preform manufactured according to some non-limiting embodiments or aspects of the presently disclosed subject matter is shown. This reaction bonded preform was produced via 3D DLP using a SiC slurry having a dispersing agent. Microstructure evaluation in FIG. 9 at 700x shows the infiltrated preform has about 60 vol.% SiC content and shows the 12 µm SiC particles are distributed uniformly in the matrix and surrounded by the residual Si.

Of particular interest are ceramic components made by the slurries and processes disclosed herein. For example, vacuum wafer chucks such as shown in FIG. 6 may be produced using disclosed photocuring ceramic slurries. Such wafer chucks may include a main body portion, and discrete pins for supporting a semiconductor wafer, wherein the pins are located at least partially within the main body portion.

Additionally, heat management or micro-channel cooler devices such as heat-sink devices may be produced. Such micro-channel cooler devices may be used in high power microelectronic cooling applications (e.g., server farms, AI devices, etc.). In some non-limiting embodiments, a heat management device, comprises: a ceramic body having a network of channels defined in a surface of the ceramic body and produced using disclosed photocuring ceramic slurries.

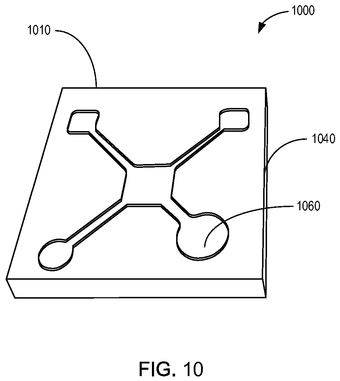

An example of a micro-channel cooler device 1000 is shown in FIG. 10. Micro-channel cooler device includes a ceramic body 1010 and may be modified to form a heat sink 1040 by defining channels 1060 in a surface of the ceramic body 1010 and/or by attaching an extension component (not shown) to the ceramic body 1010. The ceramic body 1010 is shown as having a square-shaped top view, but it will be appreciated that any suitable shape of the ceramic body 1010 may be used. Non-limiting examples of the ceramic materials from which the ceramic body 1010 may be formed include silicon carbide (SiC), boron carbide (B₄C), or any combination thereof.

As shown in FIG. 10, a network of channels 1060 may be defined in the surface of the ceramic body 1010. The arrangement and dimensions of the network of channels 1060 is non-limiting, and it will be appreciated that other arrangements and dimensions of channels 1060 may be used in connection with the present disclosure. The arrangement of the channels 1060 may refer to a number of channels 1060 and/or a direction in which the channels 1060 are defined and/or a shape of the channels 1060 and/or an overall selection of the position of the channels 1060 in the ceramic body 1010. The dimensions of the channels 1060 may refer to the length and/or width and/or depth of the channels 1060. The arrangement and dimensions of the channels 1060 in the ceramic body 1010 may be selected to optimize the heat management capabilities.

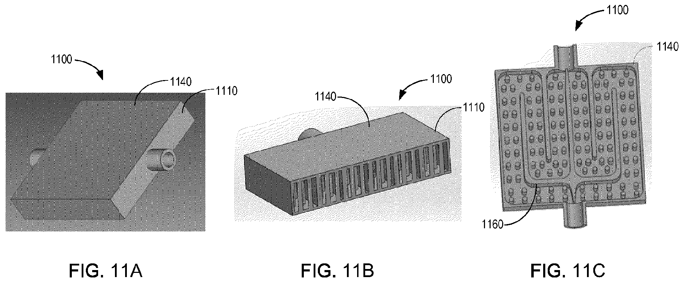

For example, as the dimensions of the channels or grooves may range from about 0.2 to 5 mm in length, width, and/or depth. Additionally, while shown as on the surface of ceramic body 1010, it is appreciated that the channels or grooves may be internal to the ceramic body 1010. This may be achieved during the DLP printing process, where individual layers may include voids or absence of material (resin) where a channel or groove is desired. Examples illustrating internal grooves and/or channels are provided in FIGS. 11-12.

In accordance with principles of the disclosure, the ceramic body 1010 and arrangement of channels 1060 are produced via DLP printing using a ceramic slurry including a dispersing agent. The produced polymer preform may then be drained, such as shown in FIG. 6B and thereafter carbonized. As shown in FIGS. 7-8, the carbonized preform material may be reaction bonded (e.g., by the silicon or boron reactive infiltration process) to form a reaction bonded ceramic component. In some non-limiting embodiments, the reaction bonded ceramic component incudes a silicon carbide and/or a boron carbide body.

Turning now to FIG. 11, an example of a micro-channel cooler device 1100 is shown. FIG. 11A shows a perspective top view of device 1100, FIG. 11B shows a perspective front cut-away view of device 1100, where a plurality of internal channels 1160 can be seen, and FIG. 11C shows a top cut-away view of device 1100, where a plurality of chambers formed from channels 1160 can be seen.

Micro-channel cooler device includes a ceramic body 1110 and may be modified to form a heat sink 1140 by defining channels 1160 in an internal surface of the ceramic body 1110. The ceramic body 1110 is shown as having a square-shaped top view, but it will be appreciated that any suitable shape of the ceramic body 1110 may be used. Non-limiting examples of the ceramic materials from which the ceramic body 1110 may be formed include silicon carbide (SiC), boron carbide (B₄C), or any combination thereof.

As shown in FIG. 11, a network of internal channels 1160 may be defined in an internal surface of the ceramic body 1110. The arrangement and dimensions of the network of channels 1160 is non-limiting, and it will be appreciated that other arrangements and dimensions of channels 1160 may be used in connection with the present disclosure. The arrangement of the channels 1160 may refer to a number of channels 1160 and/or a direction in which the channels 1160 are defined and/or a shape of the channels 1160 and/or an overall selection of the position of the channels 1160 in the ceramic body 1110. The dimensions of the channels 1160 may refer to the length and/or width and/or depth of the channels 1160. The arrangement and dimensions of the channels 1160 in the ceramic body 1110 may be selected to optimize the heat management capabilities.

For example, as the dimensions of the channels or grooves may range from about 0.2 to 5 mm in length, width, and/or depth. Additionally, while shown as on the surface of ceramic body 1110, it is appreciated that the channels or grooves may be internal to the ceramic body 1110. This may be achieved during the DLP printing process, where individual layers may include voids or absence of material (resin) where a channel or groove is desired.

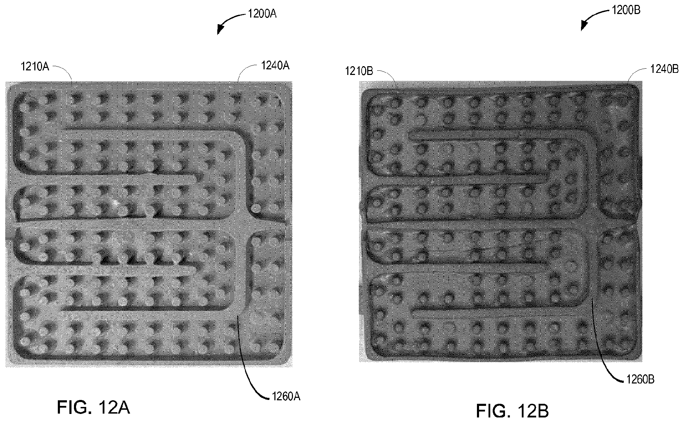

Turning now to FIGS. 12A-12B, a top view of a ceramic body formed as a micro-cooler thermal management device as a preform (FIG. 12A) and reaction bonded (FIG. 12B) are provided.

In FIG. 12A, micro-channel cooler device 1200a may be a heat sink 1240a having a network of internal channels 1260a defined in an internal surface of a ceramic body 1210a. As can be appreciated, FIG. 12A corresponds to a SiC preform based on the example shown in FIG. 11, with the inlet and outlet ports removed.

Similarly, in FIG. 12B, micro-channel cooler device 1200b may be a heat sink 1240b having a network of internal channels 1260b defined in an internal surface of a ceramic body 1210b. In FIG 12, micro-channel cooler device 1200b is the same as micro-cooler device 1200a, except that device 1200b has been subjected to a carbonization or pyrolysis process (e.g., Si infiltration) to produce a reaction bonded ceramic part.

It should be appreciated that device 1200a is slightly larger than device 1200b (32.1 mm for width of 1200a vs 29.3 mm for width of 1200b). This corresponds to about a 9% shrinkage and can be expected from reaction bonding or Si infiltration process. In some non-limiting embodiments or aspects, the total shrinkage from this step is preferably less than about 15%, more preferably less than about 10%, and most preferably less than about 5%.

Although the disclosed subject matter has been described in detail for the purpose of illustration based on what is currently considered to be the most practical and preferred embodiments or aspects, it is to be understood that such detail is solely for that purpose and that the disclosed subject matter is not limited to the disclosed embodiments or aspects, but, on the contrary, is intended to cover modifications and equivalent arrangements that are within the spirit and scope of the appended claims. For example, it is to be understood that the presently disclosed subject matter contemplates that, to the extent possible, one or more features of any embodiment or aspect can be combined with one or more features of any other embodiment or aspect.

## Claims

1. A photocuring ceramic slurry comprising:
50 to 70 wt. % opaque ceramic particles;
30 to 50 wt. % light curing resin;
0.3 to 1 wt. % dispersing agent; and
wherein the dispersing agent promotes light to penetrate and cure the photocuring slurry.

2. The slurry of claim 1, further comprising:
0 to 5 wt. % photoinitiator.

3. The slurry of claim 1 or claim 2, wherein the opaque ceramic particles are selected from the group consisting of silicon carbide, boron carbide, silicon nitride, and titanium diboride. and preferably wherein the opaque ceramic particles comprise an average particle size of from 5-30 µm.

4. The slurry of any preceding claim, wherein the slurry further comprises elemental silicon.

5. The slurry of any preceding claim, wherein the light curing resin comprises an ultraviolet digital light processing resin and/or wherein the slurry has a viscosity of 1,000 to 30,000 cps at temperatures ranging from 20 to 50°C and/or wherein the dispersing agent causes the slurry to have a light transmission depth of 25 µm or more.

6. A method of making a ceramic component from a photocuring slurry, the method comprising:
placing the photocuring slurry in a light curing resin tank, wherein the photocuring slurry comprises:
50 to 70 wt. % opaque ceramic particles;
30 to 50 wt. % light curing resin; and
0.3 to 1 wt. % dispersing agent,
subjecting the slurry to light to cause a portion of the slurry react and form a preform ceramic component; and
reaction bonding the preform ceramic component to yield a ceramic component.

7. The method of claim 6, wherein the method is performed using a digital light processing three-dimensional printer and/or wherein subjecting the slurry to light comprises: providing ultraviolet (UV) light to a section of the slurry in the light curing resin tank using an UV light source, wherein the UV light is provided at about 300 to 450 nm wavelength.

8. The method of claim 6 or claim 7, further comprising:
projecting a two-dimensional image of each layer of the preform ceramic component; and
curing each layer of the preform ceramic component using an ultraviolet light source to form the preform ceramic component optionally, wherein one or more layers of the preform ceramic component include surface features comprising channels or grooves and preferably wherein the channel or groove size ranges from about 0.2 to 5 mm in length, width, and/or depth.

9. The method of any of claims 6 to 8, further comprising:
draining any unreacted slurry from the preform ceramic component and/or further comprising:
pyrolizing the preform ceramic component to pyrolyze any remaining resin into carbon.

10. The method of any of claims 6 to 9, wherein reaction bonding comprises Si infiltration and/or wherein the reaction bonded ceramic component comprises silicon carbide, boron carbide, pure carbon, silicon nitride, and/or titanium diboride.

11. A vacuum wafer chuck comprising:
a main body portion, and
discrete pins for supporting a semiconductor wafer, wherein the pins are located at least partially within the main body portion, wherein the main body portion and pins are formed from a photocuring ceramic slurry comprising:
50 to 70 wt. % opaque ceramic particles;
30 to 50 wt. % light curing resin; and
0.3 to 1 wt. % dispersing agent.

12. A heat management device, comprising:
a ceramic body; and
a network of channels defined in a surface of the ceramic body, wherein the ceramic body is formed from a photocuring ceramic slurry comprising:
50 to 70 wt. % opaque ceramic particles;
30 to 50 wt. % light curing resin; and
0.3 to 1 wt. % dispersing agent.

13. The heat management device of claim 12, wherein the ceramic body comprises a silicon carbide and/or a boron carbide body.

14. A heat management device, comprising:
a ceramic body; and
a network of internal channels and/or chambers in the ceramic body, wherein the ceramic body is formed from a photocuring ceramic slurry comprising:
50 to 70 wt. % opaque ceramic particles;
30 to 50 wt. % light curing resin; and
0.3 to 1 wt. % dispersing agent.

15. The heat management device of claim 14, wherein the ceramic body comprises silicon carbide and is formed by digital light processing 3D printing and/or wherein the channel or chamber size ranges from about 0.2 to 5 mm in length, width, and/or depth.

## Amended claims

### Amended claims in accordance with Rule 137(2) EPC.

1. A photocuring ceramic slurry comprising:
50 to 70 wt. % opaque ceramic particles;
30 to 50 wt. % light curing resin;
0.3 to 1 wt. % dispersing agent; and
wherein the dispersing agent promotes light to penetrate and cure the photocuring slurry.

2. The slurry of claim 1, further comprising:
0 to 5 wt. % photoinitiator.

3. The slurry of claim 1 or claim 2, wherein the opaque ceramic particles are selected from the group consisting of silicon carbide, boron carbide, silicon nitride, and titanium diboride.

4. The slurry of any preceding claim, wherein the slurry further comprises elemental silicon.

5. The slurry of any preceding claim, wherein the light curing resin comprises an ultraviolet digital light processing resin and/or wherein the slurry has a viscosity of 1,000 to 30,000 cps at temperatures ranging from 20 to 50°C and/or wherein the dispersing agent causes the slurry to have a light transmission depth of 25 µm or more.

6. A method of making a ceramic component from a photocuring slurry, the method comprising:
placing the photocuring slurry in a light curing resin tank, wherein the photocuring slurry comprises:
50 to 70 wt. % opaque ceramic particles;
30 to 50 wt. % light curing resin; and
0.3 to 1 wt. % dispersing agent,
subjecting the slurry to light to cause a portion of the slurry react and form a preform ceramic component; and
reaction bonding the preform ceramic component to yield a ceramic component.

7. The method of claim 6, wherein the method is performed using a digital light processing three-dimensional printer and/or wherein subjecting the slurry to light comprises: providing ultraviolet (UV) light to a section of the slurry in the light curing resin tank using an UV light source, wherein the UV light is provided at about 300 to 450 nm wavelength.

8. The method of claim 6 or claim 7, further comprising:
projecting a two-dimensional image of each layer of the preform ceramic component; and
curing each layer of the preform ceramic component using an ultraviolet light source to form the preform ceramic component optionally, wherein one or more layers of the preform ceramic component include surface features comprising channels or grooves and preferably wherein the channel or groove size ranges from about 0.2 to 5 mm in length, width, and/or depth.

9. The method of any of claims 6 to 8, further comprising:
draining any unreacted slurry from the preform ceramic component and/or further comprising:
pyrolizing the preform ceramic component to pyrolyze any remaining resin into carbon.

10. The method of any of claims 6 to 9, wherein reaction bonding comprises Si infiltration and/or wherein the reaction bonded ceramic component comprises silicon carbide, boron carbide, pure carbon, silicon nitride, and/or titanium diboride.

11. A vacuum wafer chuck comprising:
a main body portion, and
discrete pins for supporting a semiconductor wafer, wherein the pins are located at least partially within the main body portion, wherein the main body portion and pins are formed from a photocuring ceramic slurry comprising:
50 to 70 wt. % opaque ceramic particles;
30 to 50 wt. % light curing resin; and
0.3 to 1 wt. % dispersing agent.

12. A heat management device, comprising:
a ceramic body; and
a network of channels defined in a surface of the ceramic body, wherein the ceramic body is formed from a photocuring ceramic slurry comprising:
50 to 70 wt. % opaque ceramic particles;
30 to 50 wt. % light curing resin; and
0.3 to 1 wt. % dispersing agent.

13. The heat management device of claim 12, wherein the ceramic body comprises a silicon carbide and/or a boron carbide body.

14. A heat management device, comprising:
a ceramic body; and
a network of internal channels and/or chambers in the ceramic body, wherein the ceramic body is formed from a photocuring ceramic slurry comprising:
50 to 70 wt. % opaque ceramic particles;
30 to 50 wt. % light curing resin; and
0.3 to 1 wt. % dispersing agent.

15. The heat management device of claim 14, wherein the ceramic body comprises silicon carbide and is formed by digital light processing 3D printing and/or wherein the channel or chamber size ranges from about 0.2 to 5 mm in length, width, and/or depth.
